# EUROPEAN PATENT SPECIFICATION

(11) **EP 0 514 316 B1**
(45) Date of publication and mention of the grant of the patent: **27.03.1996**
(21) Application number: 92610033.0
(22) Date of filing: 12.05.1992
(51) Int. Cl.: H03H 1/00, H03H 3/00

(54) **An LC-circuit and a method of producing said LC-circuit**
LC-Schaltung und Herstellungsverfahren dieser LC-Schaltung
Circuit-LC et procédé de fabrication de ce circuit-LC

(30) Priority: 14.05.1991 DK 908/91
(43) Date of publication of application: 19.11.1992
(73) Proprietor: FERROPERM COMPONENTS APS, DK-3000 Helsingör (DK)
(72) Inventor: Holm, Jens Peter, Dk-2970 Horsholm (DK)
(74) Representative: Siiger, Joergen

(56) References cited:
- EP-A- 0 297 565
- US-A- 4 746 557
- US-A- 4 918 570

## Description

The invention relates to an LC-circuit in form of a single component, where the inductor and capacitor elements are arranged atop one another, and where the inductor elements are formed by ferromagnetic zones composed of layers of ferrite paste of a high permeability, electrode layers of electrode paste being provided between said layers of ferrite paste, and where the capacitor elements are formed by dielectric zones composed of layers of dielectric paste with electrode layers on both sides, said inductor and capacitor elements being produced by way of thick-film technology on a substrate.

The use of ferrimagnetic materials for chip components comprising both inductor and capacitor elements has previously been limited by the difficulty in using ferrimagnetic materials in connection with dielectric materials. The inductor elements are often made of a ferrite paste and are by means of known printing methods used for the production of layer structures including internal conducting paths. These inductor elements have low inductances due to the low permeability of the ferromagnetic material. EP-PS No. 297 565 discloses for instance a ferrimagnetic material of a relatively low permeability caused by a very small granular size and a high content of glass. Attempts have been made at obtaining a higher permeability by raising the sintering temperature or increasing the sintering period, but from a productional point of view such procedures are disadvantageous or necessitate the use of cost-intensive electrode materials, such as Pd. The material described in EP-PS No. 297 565 requires for instance a sintering period of 30 to 220 min, which makes a production under usual thick-film conditions difficult. Furthermore, the final components have a relatively poor mechanical strength, which also applies to the components described in the Japanese Patent Applications Nos. 58-135,133 and 58-135,606.

In addition, the chip components comprising both inductor and capacitor elements suffer from delamination and distortion at the transition zones between the ferrimagnetic and the dielectric zones. Chip components comprising both inductor and capacitor elements are furthermore encumbered with problems due to reactions at the transition zones between the ferrimagnetic and the dielectric zones with the result that the characteristics of said materials are deteriorated.

The object of the present invention is to provide an LC-component of the above type, where the ferrite paste used has a relatively high permeability, is mechanically stable, and is suited for mass production.

The LC-component according to the invention is characterised in that the ferromagnetic zones are separated from the dielectric zones of the capacitor element by means of a blocking layer, and that electric conduits are provided on the outer side of the component both for the inductor elements and for the capacitor elements. The resulting component is very stable and allows the use of a ferrite of a high permeability because said ferrite does not come into direct contact with the dielectric zones. The electric conduits along the outer side of the component allow the use of continuous blocking layers with the result that reactions are avoided between the dielectric and the ferrimagnetic zones. Through holes would otherwise cause such reactions. The ferrite is advantageously of a granular size exceeding 1 µ and contains more than 15% by weight of glass as well as it is sintered at 800 to 950°C for more than 30 min. As a result, it is possible to use electrodes made of Ag or Ag/Pd, and the ferrite obtains a permeability exceeding 20 without requiring a too high sintering temperature or a too long sintering period. Accordingly the component is suited for mass production.

The invention relates furthermore to a method of producing an LC-circuit in form of a single component, where the inductor and capacitor elements are arranged atop one another, and where the inductor elements are formed by ferromagnetic zones composed of layers of ferrite paste of a high permeability, electrode layers of electrode paste being provided between said layers of ferrite paste, and where the capacitor elements are formed by dielectric zones composed of layers of dielectric paste with electrode layers on both sides, said inductor and capacitor elements being produced by way of thick-film technology on a substrate. The method is according to the invention characterised by separating the ferromagnetic zones from the dielectric zones of the capacitor elements by means of a blocking layer, and by providing electric conduits on the outer side of the component both for the inductor elements and for the capacitor elements. This method is particularly suited for the production of the LC-circuit.

The invention relates furthermore to a method of producing a ferrite paste to be used by the production of an LC-circuit, said method being characterised by containing lithium, manganese, cobalt, zinc, titanium, iron, and oxygen and being composed as follows
Li_{0,5(1+t-z-c)}Zn_{z},Mnₘ,Tiₜ,Coₒ,Fe_{(1-0,2z-0,6t-0,4m-0,2c-ε)}
where 0≤t≤0,2; 0,2≤z≤0,5; 0,2≤m≤0,4; 0,02≤c≤0,05; and ε is of the magnitude 0,06,

said material being mixed in a ball mill followed by drying and presintering of the mixture at about 750°C for about one hour, whereafter Bi₂O₃ is added and the mixture is ground to a granular size of less than 1 µ and dried and sintered at about 910°C for two hours and then ground, dried, and sintered to remove agglomerates, whereafter glass is mixed therein followed by a grinding of said mixture.

A paste is produced from the above material, said paste being sinterable at low temperature in a relatively short period. The material is characterised by a large granular size in both the paste and the sintered material, and by addition of a low amount of glass. The resulting paste can be sintered under usual thick-film production conditions and presents a high permeability.

The placing of the component on the substrate results in a mechanically stable component suited for fast production methods.

The invention is explained in greater detail below with reference to the accompanying drawing, in which
Figure 1 is an exploded view of an LC-circuit in form of a component according to the invention,
Figure 2 is a sectional view of the LC-component, and
Figure 3 shows a diagram of the LC-circuit.

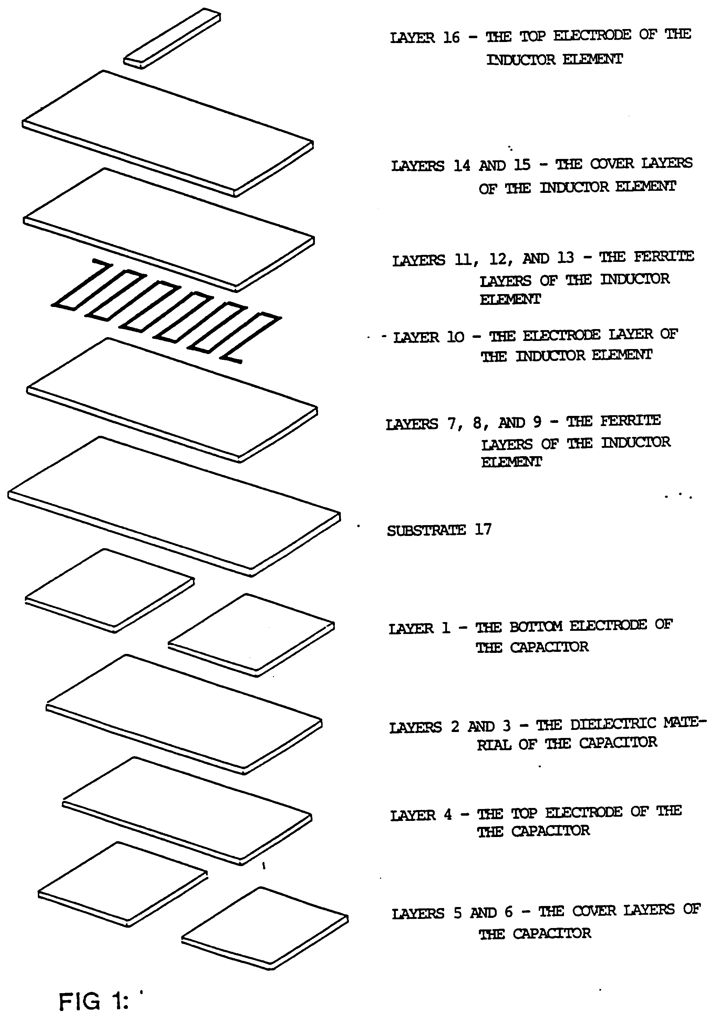

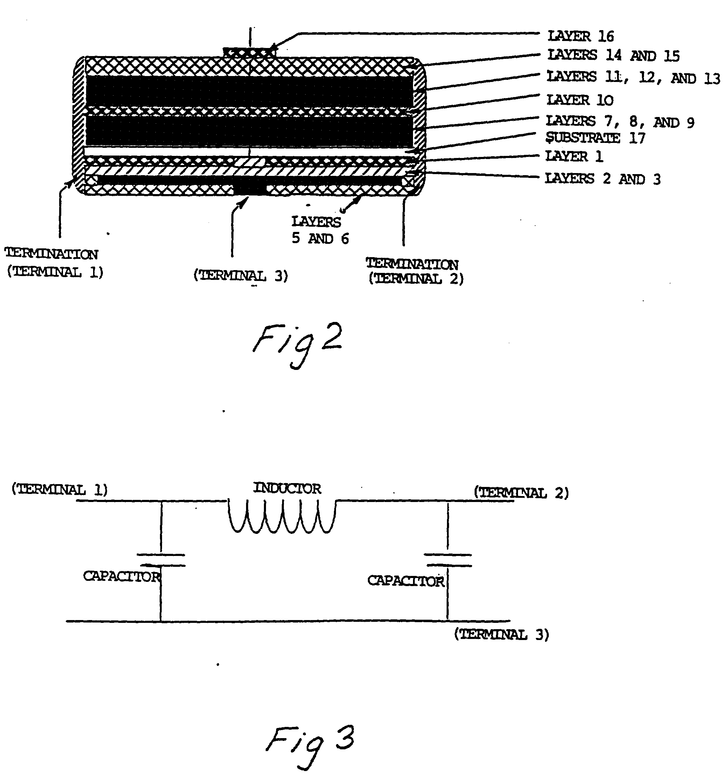

The LC-circuit shown in Figures 1 and 2 in form of a single component comprises two capacitor elements and an inductor element. The capacitor elements and the inductor element are arranged on each side of a blocking layer being a substrate of Al₂O₃ in the illustrated embodiment. Figures 1 and 2 illustrate the structure of the LC-component with the individual printing layers. Initially, the capacitor side is printed on the possibly scribed side of the substrate 17, whereafter layer number 1 is printed with electrode paste made of Ag or Ag/Pd, said layer number 1 being the bottom electrode of the capacitor elements. The layer is dried at 130°C for 15 min. and sintered at 850°C for 10 min. The layers number 2 and 3 are the dielectrics of the capacitor elements and are printed with dielectric paste. The layers are dried individually at 130°C and together sintered at 850°C for 10 min. Layer number 4 is the top electrode of the capacitor element and is printed with electrode paste of Ag or Ag/Pd, whereafter it is dried at 130°C for 15 min. and sintered at 850°C for 10 min. Layers number 5 and 6 are the cover layers of the capacitor element and are printed with cover paste, dried individually at 130°C for 15 min. and together sintered at 850°C for 10 min. Layers number 7, 8, and 9 are the ferrite layers of the inductor element and are printed with the described ferrite paste and dried individually at 130°C for 15 min followed by a simultaneous sintering of all the layers at 850°C for 10 min. Layer number 10 is a meanderformed electrode layer of the inductor element and is printed with electrode paste Ag or Ag/Pd and dried at 130°C for 15 min and sintered at 850°C for 10 min. Layers number 11, 12, and 13 are also ferrite layers and are printed with ferrite paste and dried at 130°C for 15 min and sintered at 850°C for 10 min. Layers number 14 and 15 represent the cover layers of the inductor element and are printed with the described cover paste and dried at 130°C for 15 min and sintered at 850°C for 10 min. Layer number 16 is the top electrode of the inductor element and is printed with electrode paste of Ag/Ph and dried at 130°C for 15 min and sintered at 850°C for 10 min. Finally, both ends of the component are immersed in terminating paste containing Ag/Ph.

The terminating paste does not appear from Figure 1, but is shown in Figure 2, whereas Figure 3 illustrates the corresponding circuit diagram.

A ferrite material is used which contains lithium, manganese, cobalt, zinc, titanium, iron, and oxygen and which is composed as follows
Li_{0,5(1+t-z-c)}Zn_{z},Mnₘ,Tiₜ,Coₒ,Fe_{(1-0,2z-0,6t-0,4m-0,2c-ε)}
where 0≤t≤0,2; 0,2≤z≤0,5; 0,2≤m≤0,4; 0,02≤c≤0,05; and ε is of the magnitude 0,06.

The material is mixed in a ball mill with stainless steel balls, whereafter the mixture is dried and presintered at about 750°C for one hour. Then Bi₂O₃ is added in an amount of 0.2 to 5.0% by weight, and the mixture is ground in the ball mill to a granular size of less than 1 µ. Then the material is dried and sintered at 910°C for two hours and subsequently ground again in the ball mill and dried and sintered to remove agglomerates. The granular size has now been increased to 2.0 µ. 6% of lead boric silicate glass is added to the ferrite material, whereafter the mixture is ground/mixed for 48 hours in a ball mill in acetone, which does not reduce the granular size of the ferrite, but the granular size of the glass. Then the material is dried and screened. The ferrite material is mixed with 10% of binder, such as ethyl cellulosis, and diluent, such as terpineole, in a mixer for 1 hour, whereafter the optionally adjustable viscosity is controlled.

The resulting paste can be sintered at low temperature and in a relatively short period of time. The material is characterised by the granular size of both the paste and of the sintered material being large, and by the amount of added glass compounds being low. Accordingly, a paste is obtained which can be sintered under usual thick-film production conditions and which provides a high permeability. As the component is placed on the substrate it is possible to obtain a mechanically stable component suited for fast production methods. The insertion of a blocking layer between the ferromagnetic zones and the dielectric zones prevents reactions between said materials. The blocking layer is optionally formed by the substrate, but may alternatively be formed by a crystalline glass layer. The electric conduits along the outer side of the component allow the use of continuous blocking layers with the result that reactions are avoided between the dielectric and the ferrimagnetic zones. Through holes would otherwise cause such reactions.

The individual layers are of a thickness of 5 to 60 µ.

Each capacitor element presents a value of 10 pF to 10 µF, whereas the inductor element presents a value of 20 nH to 10 µH.

## Claims

1. An LC-circuit in form of a single component, where the inductor and capacitor elements are arranged atop one another, and where the inductor elements are formed by ferromagnetic zones composed of layers (7, 8, 9, 11, 12, 13) of ferrite paste of a high permeability, electrode layers (10) of electrode paste being provided between said layers of ferrite paste, and where the capacitor element are formed by dielectric zones composed of layers (2,3) of dielectric paste with electrode layers (1,4) on both sides, said inductor and capacitor elements being produced by way of thick-film technology on a substrate, characterised in that the ferromagnetic zones are separated from the dielectric zones of the capacitor element by means of a blocking layer (17), and that electric conduits (16) are provided on the outer side of the component both for the inductor elements and for the capacitor elements.

2. A method of producing an LC-circuit as claimed in claim 1 and in form of a single component, where the inductor and capacitor elements are arranged atop one another, and where the inductor elements are formed by ferromagnetic zones composed of layers of ferrite paste of a high permeability, electrode layers of electrode paste being provided between said layers of ferrite paste, and where the capacitor elements are formed by dielectric zones composed of layers of dielectric paste with electrode layers on both sides, said inductor and capacitor elements being produced by way of thick-film technology on a substrate, characterised by separating the ferromagnetic zones from the dielectric zones of the capacitor elements by means of a blocking layer, and by providing electric conduits on the outer side of the component both for the inductor elements and for the capacitor elements.

3. A method as claimed in claim 2, characterised by the blocking layer being formed by a crystalline glass layer.

4. A method as claimed in claim 2, characterised by the blocking layer being formed by the substrate (17).

5. A method as claimed in claims 2 to 4, characterised by the ferrite being of a granular size exceeding 1 µ and containing more than 15% by weight of glass as well as being sintered at 800 to 950°c for more than 30 min.

6. A method as claimed in claims 2 to 5 in which said ferrite paste is obtained by a method characterised by using a material containing lithium, manganese, cobalt, zinc, titanium, iron, and oxygen and being composed as follows
Li_{0,5(1+t-z-c)}Zn_{z},Mnₘ,Tiₜ,Coₒ,Fe_{(1-0,2z-0,6t-0,4m-0,2c-ε)}
where 0≤t≤0,2; 0,2≤z≤0,5; 0,2≤m≤0,4; 0,02≤c≤0,05;
and ε is of the magnitude 0,06,
said material being mixed in a ball mill followed by drying and presintering of the mixture at about 750°C for about one hour, whereafter Bi₂O₃ is added and the mixture is ground to a granular size of less than 1 µ and dried and sintered at about 910°C for two hours and then ground, dried, and sintered to remove agglomerates, whereafter glass is mixed therein followed by a grinding of said mixture.

## Patentansprüche

1. LC-Schaltung in Form einer einzigen Komponente, in der die Induktions- und Kondensatorelemente übereinander angeordnet sind, und in der die Induktionselemente aus ferromagnetischen Zonen gebildet sind, die aus Lagen (7, 8, 9, 11, 12, 13) aus Ferritpaste mit einer hohen Permeabilität zusammengesetzt sind, wobei Elektrodenlagen (10) aus Elektrodenpaste zwischen besagten Lagen aus Ferritpaste bereitgestellt sind, und in der die Kondensatorelemente aus dielektrischen Zonen gebildet sind, die aus Lagen (2, 3) aus dielektrischer Paste mit Elektrodenlagen (1, 4) auf beiden Seiten zusammengesetzt sind, wobei die Induktions- und Kondensatorelemente mittels einer Dickfilmtechnologie auf ein Substrat hergestellt sind, dadurch gekennzeichnet, daß die ferromagnetischen Zonen von den dielektrischen Zonen des Kondensatorelements mittels einer Blokkierlage (17) getrennt sind, und daß elektrische Leitungen (16) an der Außenseite der Komponente sowohl für die Induktionselemente als auch für die Kondensatorelemente bereitgestellt sind.

2. Verfahren zum Herstellen eine LC-Schaltung nach Anspruch 1 und in Form einer einzigen Komponente, in der die Induktions-und Kondensatorelemente übereinander angeordnet werden, und in der die Induktionselemente aus ferromagnetischen Zonen gebildet werden, die aus Lagen aus Ferritpaste mit einer hohen Permeabilität zusammengesetzt werden, wobei Elektrodenlagen aus Elektrodenpaste zwischen besagten Lagen aus Ferritpaste bereitgestellt werden, und in der die Kondensatorelemente aus dielektrischen Zonen gebildet werden, die aus Lagen einer dielektrischen Paste mit Elektrodenlagen auf beiden Seiten zusammengesetzt werden, wobei die Induktions- und Kondensatorelemente mittels einer Dickfilmtechnologie auf ein Substrat hergestellt werden, dadurch gekennzeichnet, daß die ferromagnetischen Zonen von den dielektrischen Zonen des Kondensatorelements mittels einer Blockierlage getrennt werden, und daß die elektrischen Leitungen an der Außenseite der Komponente sowohl für die Induktionselemente als auch für die Kondensatorelemente bereitgestellt werden.

3. Verfahren nach Anspruch 2, dadurch gekennzeichnet, daß die Blockierlage durch eine Kristallglaslage gebildet wird.

4. Verfahren nach Anspruch 2, dadurch gekennzeichnet, daß die Blockierlage durch das Substrat (17) gebildet wird.

5. Verfahren nach einem der Ansprüche 2 bis 4, dadurch gekennzeichnet, daß das Ferrit eine Korngröße aufweist, die 1 µ übersteigt, und mehr als 15 Gew.-% Glas enthält sowie bei 800 bis 950°C für mehr als 30 Minuten gesintert wird.

6. Verfahren nach einem der Ansprüche 2 bis 5, bei welchem besagte Ferritpaste durch ein Verfahren erhalten wird, das gekennzeichnet ist durch Verwenden eines Materials umfassend Lithium, Mangan, Kobalt, Zink, Titan, Eisen und Sauerstoff sowie wie folgt zusammengesetzt wird
Li_{0,5(1+t-z-c)}Zn_{z}, Mnₘ, Tiₜ, Coₒ, Fe_{(1.0, 2z-0, 6t-0,4m-0,2c-ε)}
wobei 0 ≤ t ≤ 0,2; 0,2 ≤ z ≤ 0,5; 0,2 ≤ m ≤ 0,4; 0,02 ≤ c ≤ 0,05; und ε von der Größe 0,06 ist,
wobei besagtes Material in einer Kugelmühle gemischt wird, gefolgt von Trocknen und Vorsintern der Mischung bei 750°C für ungefähr 1 Stunde, wonach Bi₂O₃ hinzugefügt und die Mischung auf eine Korngröße von weniger als 1 µ granuliert und getrocknet sowie gesintert bei ungefähr 910°C für 2 Stunden und dann granuliert, getrocknet sowie gesintert wird, um Agglomerate zu entfernen, wonach Glas darin gemischt wird, gefolgt von einer Zermahlung besagter Mischung.

## Revendications

1. Circuit LC sous forme d'un composant unique, dans lequel les éléments formant inductance et condensateur sont disposés les uns au-dessus des autres, et dans lequel les éléments formant inductance sont formés par des zones ferromagnétiques constituées de couches (7,8,9,11,12,13) de pâte de ferrite possédant une haute perméabilité, des couches d'électrodes (10) formées d'une pâte à électrodes étant disposées entre lesdites couches de pâte de ferrite, et dans lequel les éléments formant condensateur sont formés par des zones diélectriques constituées de couches (2,3) de pâte diélectrique, avec des couches d'électrodes (1,4) des deux côtés, lesdits éléments formant inductance et condensateur étant fabriqués au moyen de la technique des couches épaisses, sur un substrat, caractérisé en ce que les zones ferromagnétiques sont séparées des zones diélectriques de l'élément formant condensateur au moyen d'une couche d'arrêt (17), et en ce que des conduits électriques (16) sont prévus sur la face extérieure du composant à la fois pour les éléments formant inductance et pour les éléments formant condensateur.

2. Procédé pour fabriquer un circuit LC selon la revendication 1, et se présentant sous la forme d'un seul composant, dans lequel les éléments formant inductance et condensateur sont disposés les uns au-dessus des autres, et dans lequel les éléments formant inductance sont formés par des zones ferromagnétiques constituées de couches de pâte de ferrite possédant une haute perméabilité, des couches d'électrodes formées d'une pâte à électrodes étant disposées entre lesdites couches de pâte de ferrite, et dans lequel les éléments formant condensateur sont formés par des zones diélectriques constituées de couches de pâte diélectrique, avec des couches d'électrodes des deux côtés, lesdits éléments formant inductance et condensateur étant fabriqués au moyen de la technique des couches épaisses, sur un substrat, caractérisé en ce qu'il consiste à séparer les zones ferromagnétiques, des zones diélectriques des éléments formant condensateur au moyen d'une couche d'arrêt et à prévoir des conduits électriques sur la face extérieure du composant à la fois pour les éléments formant inductance et pour les éléments formant condensateur.

3. Procédé selon la revendication 2, caractérisé en ce que la couche d'arrêt est formée par une couche de verre cristallin.

4. Procédé selon la revendication 2, caractérisé en ce que la couche d'arrêt est formée par le substrat (17).

5. Procédé selon les revendications 2 à 4, caractérisé en ce que la ferrite possède une taille de grains dépassant 1 µm et contient plus de 15% en poids de verre et est également frittée entre 800 et 950°C pendant plus de 30 mn.

6. Procédé selon les revendications 2 à 5, selon lequel ladite pâte de ferrite est obtenue au moyen d'un procédé caractérisé par l'utilisation d'un matériau contenant du lithium, du manganèse, du cobalt, du zinc, du titane, du fer et de l'oxygène et ayant la composition suivante :
Li_{0,5(1+t-z-c)}Zn_{Z}, Mnₘ,Tiₜ,Coₒ, Fe(_{1-0,2z-0,6t-0,4m-0,2c-ε} )
avec 0≤t≤0,2; 0,2≤z≤0,5; 0,2≤m≤0,4; 0,02≤c≤0,05; et ε possédant la valeur 0,06,
ledit matériau étant mélangé dans un broyeur à boulets, ceci étant suivi par un séchage et un préfrittage du mélange à environ 750°C pendant environ une heure, à la suite de quoi du Bi₂O₃ est ajouté et le mélange est broyé de manière à avoir une taille de grains inférieure à 1 µm et est séché et fritté à environ 910°C pendant deux heures, puis est broyé, séché et fritté afin d'en éliminer des agglomérats, à la suite de quoi du verre y est mélangé, cette opération étant suivie par un broyage dudit mélange.
